Europäisches Patentamt

European Patent Office

Office européen des brevets

(11) Veröffentlichungsnummer: **0 262 427**
**A2**

(12) **EUROPÄISCHE PATENTANMELDUNG**

(21) Anmeldenummer: **87112723.9**

(22) Anmeldetag: **01.09.87**

(51) Int. Cl.4: **H05K 5/02**

(30) Priorität: **30.09.86 DE 3633248**

(43) Veröffentlichungstag der Anmeldung:
**06.04.88 Patentblatt 88/14**

(84) Benannte Vertragsstaaten:
**AT BE CH DE ES FR GB GR IT LI LU NL SE**

(71) Anmelder: **Rittal-Werk Rudolf Loh GmbH & Co. KG**
**Auf dem Stützelberg**
**D-6348 Herborn(DE)**

(72) Erfinder: **Berg, Franco**
**Am Walde 2**
**D-3304 Isernhagen(DE)**
Erfinder: **Bovermann, Claus-Dieter**
**Am Oberg 7**
**D-3565 Breidenbach-Niederdieten(DE)**

(74) Vertreter: **Vogel, Georg**
**Hermann-Essig-Strasse 35**
**D-7141 Schwieberdingen(DE)**

(54) **Tischgehäuse für elektrotechnische Einrichtungen.**

(57) Die Erfindung betrifft ein Tischgehäuse für elektrotechnische Einrichtungen mit zwei Seitenwänden, einem Oberteil und einem Unterteil, die einen Rahmen mit zwei mittels Rückwand, Tür oder Sichtfenster verschließbare Öffnungen bilden, bei dem in allen Eckbereichen des Ober-und des Unterteils Stellfüße schwenkbar gelagert und aus einer bündigen Einschwenkstellung in eine senkrecht zum Oberteil oder Unterteil stehende Ausschwenkstellung bringbar sind. Ein unverschiebbar gesichertes Übereinanderstapeln derartiger Tischgehäuse wird in einfacher Weise dadurch erreicht, daß zumindest die Stellfüße des Unterteils als Stapelfüße ausgebildet sind, und daß zumindest die in der Einschwenkstellung befindlichen Stapelfüße des Oberteils Stapelaufnahmen für die als Stapelenden ausgebildeten freien Enden von in die Ausschwenkstellung gebrachten Stapelfüßen benachbarter Tischgehäuse bilden.

FIG.1

# Tischgehäuse für elektrotechnische Einrichtungen

Die Erfindung betrifft ein Tischgehäuse für elektrotechnische Einrichtungen mit zwei Seitenwänden, einem Oberteil und einem Unterteil, die einen Rahmen mit zwei mittels Rückwand, Tür oder Sichtfenster verschließbare Öffnungen bilden, bei dem in allen Eckbereichen des Ober-und des Unterteils Stellfüße schwenkbar gelagert und aus einer bündigen Einschwenkstellung in eine senkrecht zum Oberteil oder Unterteil stehende Ausschwenkstellung bringbar sind.

Ein Tischgehäuse dieser Art ist aus dem DE-GM 85 11 254 bekannt. Bei diesem bekannten Tischgehäuse sind die Stellfüße als Klappen ausgebildet, die auf der Unterseite des Tischgehäuses als Stellfüße dienen, während sie auf der Oberseite des Tischgehäuses nur zur Abdeckung der Befestigungsschrauben dienen, die das Oberteil mit den Seitenteilen des Tischgehäuses verbinden. Darüberhinaus sind die Schwenkachsen der Klappen senkrecht zu den Seitenteilen des Tischgehäuses gerichtet.

Werden mehrere derartige Tischgehäuse übereinander gestellt, dann sind diese nicht gegen Verschieben gesichert. Es besteht daher die Gefahr, daß das oberste Tischgehäuse eines derartig aufeinander gesetzten Stapels bei unbeabsichtigtem Anstoßen herunterfällt. Außerdem ist die Standsicherheit des Tischgerätes bei den vier an der Unterseite herausgeklappten Stellfüßen bei dieser Ausrichtung der Schwenkachsen nicht besonders gut, wenn die Ausschwenkstellung der Stellfüße nicht verriegelt wird. Die Verriegelung erfordert aber einen erheblichen Aufwand.

Wie das DE-GM 80 25 774 zeigt, ist es bei Tischgehäusen auch schon bekannt, die Schwenkachsen der Stellfüße parallel zu den Seitenteilen des Tischgehäuses auszurichten.

Es ist Aufgabe der Erfindung, ein Tischgehäuse der eingangs erwähnten Art zu - schaffen, bei dem ein Übereinanderstapeln mit gleichartigen Tischgehäusen ermöglicht wird und die Tischgehäuse dabei auf einfache Art gegen seitliches Verschieben gesichert sind.

Diese Aufgabe wird nach der Erfindung dadurch gelöst, daß zumindest die Stellfüße des Unterteils als Stapelfüße ausgebildet sind, und daß zumindest die in der Einschwenkstellung befindlichen Stapelfüße des Oberteils Stapelaufnahmen für die als Stapelenden ausgebildeten freien Enden von in die Ausschwenkstellung gebrachten Stapelfüßen benachbarter Tischgehäuse bilden.

Allein durch die Ausbildung der Stellfüße bzw. Klappen des bekannten Tischgehäuses läßt sich so ein Ineinandergreifen übereinander gesetzter Tischgehäuse erreichen. Durch das Eingreifen der in Ausschwenkstellung befindlichen Stapelfüße eines aufgesetzten Tischgehäuses in die Stapelaufnahmen der in Einschwenkstellung befindlichen Stapelfüße des darunter angeordneten Tischgehäuses wird eine gegen seitliches Verschieben gesicherte Stellung der Tischgehäuse in einem Stapel von Tischgehäusen erhalten.

Dabei spielt der Aufbau des Tischgehäuses keine Rolle. Es kann sowohl vorgesehen sein, daß Seitenwände, Oberteil und Unterteil einen einteiligen Rahmen bilden, als auch daß die Seitenwände mit dem Oberteil und dem Unterteil verschraubt sind und daß die Stapelfüße die Befestigungsschrauben abdecken.

Um bei der Anbringung der Stapelfüße die Form des Tischgehäuses nicht zu stark zu beeinträchtigen, sieht eine Ausgestaltung vor, daß die Stapelfüße in Aussparungen schwenkbar gelagert sind, die im Bereich der Kanten in das Tischgehäuse eingebracht sind, an denen die Seitenwände auf das Oberteil oder das Unterteil stoßen.

Ist dabei vorgesehen, daß die Stapelfüße mittels Schwenkachsen gelagert sind, die parallel zu diesen Kanten ausgerichtet sind, dann wird die Standsicherheit auch des einzeln aufgestellten Tischgehäuses verbessert, ohne dafür eine Verriegelung der Stapelfüße in der Ausschwenkstellung vorsehen zu müssen, da selbst beim Einschieben von Baugruppen und dgl. in das Tischgehäuse keine Kraft auf die ausgeschwenkten Stapelfüße ausgeübt wird, die die Stapelfüße in die Einschwenkstellung bringen möchte.

Ist nach einer Ausgestaltung vorgesehen, daß zwischen den beiden Stapelfüßen der Kanten weitere Stapelaufnahmen in einheitlicher Teilung angeordnet sind, die sich aus der Breite der Stapelfüße in Längsrichtung der Kanten plus dem Abstand zwischen benachbarten Stapelaufnahmen ergibt, dann lassen sich auch ähnliche Tischgehäuse mit kleinerer Bautiefe in den Stapel einbeziehen. Dabei ist vorzugsweise vorgesehen, daß die Stapelfüße jeweils in einem Abstand von der zugekehrten Öffnung des Tischgehäuses entfernt angeordnet sind, der dem Abstand zwischen benachbarten Stapelaufnahmen entspricht, und daß die Tiefe desselben K.T + a beträgt, wobei K die Anzahl der Stapelaufnahmen plus der Stapelfüße pro Kante angibt und k gleich oder größer als zwei ist.

Einen eindeutigen Formschluß der in die Stapelaufnahmen eingeführten Stapelenden der Stapelfüße wird nach einer Ausgestaltung dadurch erreicht, daß die Stapelaufnahmen in den Kanten des Tischgehäuses und an den in Einschwenkstellung befindlichen Stapelfüßen als von den Kanten ausgehende Nuten ausgebildet sind, deren Nutgrund jeweils im Winkel von 135° zu den Außenseiten der benachbarten Seitenwand und des benachbarten Oberteils bzw. des benachbarten Unterteils steht und jeweils über einen senkrecht zu diesen stehenden Absatz in diese übergeht, und daß das Stapelende des ausgeschwenkten Stapelfußes in seiner Kontur an diesen Nutgrund mit seinen Übergängen angepaßt ist.

Der Einbau der Stapelfüße in das Tischgehäuse wird dadurch erleichtert, daß jeder Stapelfuß in einem Grundgehäuse schwenkbar gelagert ist, das in eine der Aussparungen des Tischgehäuses eingesetzt und mit diesem verbunden ist. Der Stapelfuß kann daher als Einheit mit dem Grundgehäuse vorgefertigt werden und braucht dann nur noch in die Aussparung des Tischgehäuses eingeschraubt zu werden. Dabei kann gegebenenfalls über die Befestigungsschrauben wieder das Oberteil bzw. das Unterteil mit den Seitenteilen verbunden werden.

Eine Ausgestaltung für die Schwenklagerung des Stapelfußes ist dadurch gekennzeichnet, daß das Grundgehäuse im wesentlichen U-förmig ausgebildet ist und eine Grundplatte und zwei Seitenschenkel aufweist, daß die Grundplatte an einer Stirnseite des Grundgehäuses in eine angeformte Lageraufnahme für einen Lagerblock des Stapelfußes übergeht, daß die Seitenschenkel des Grundgehäuses im Bereich dieser Lageraufnahme mit Lagerbohrungen für eine in die Lagerbohrung des Lagerblockes des Stapelfußes eingeführte Lagerwelle versehen sind, und daß die Grundplatte des Stapelfußes in der Einschwenkstellung die Seitenschenkel des Grundgehäuses überdeckt.

Eine definierte Ausschwenkstellung für den Stapelfuß ergibt sich einfach dadurch, daß die Lageraufnahme des Grundgehäuses mit Anschlagflächen versehen ist, an denen Gegenanschlagflächen des Lagerblockes des in die Ausschwenkstellung gebrachten Stapelfußes zur Anlage kommen. Der Stapelfuß steht in der Ausschwenkstellung vorzugsweise senkrecht zur Außenseite des Oberteils bzw. des Unterteils.

Der Stapelfuß selbst ist nach einer Ausgestaltung so ausgebildet, daß der Stapelfuß U-förmig gestaltet ist und aus einer Standplatte und zwei Seitenschenkeln besteht, die an dem Lagerblock angeformt sind, daß die Außenseite der Grundplatte in der Einschwenkstellung bündig mit der Außenseite des Oberteils bzw. des Unterteils abschließt, während die Seitenschenkel an der Grundplatte des Grundgehäuses anliegen, daß die dem Lagerblock abgekehrten Stirnseiten der Standplatte und der abgeschrägten Seitenschenkel das Stapelende des Stapelfußes bilden und daß die dem Lagerblock zugekehrte, als Gegenanschlagfläche dienende Stirnseite der Standplatte und der Lagerblock des Stapelfußes in Verbindung mit der bei eingeschwenktem Stapelfuß freiliegenden Anschlagfläche der Lageraufnahme des Grundgehäuses eine Stapelaufnahme bilden.

Wird auch eine Schrägstellung des Tischgehäuses auf einer Standfläche gewünscht, dann sieht eine weitere Ausgestaltung vor, daß mit dem Stapelfuß auf derselben Schwenkachse ein Stellfuß schwenkbar gelagert ist, der länger als der Stapelfuß ist und abhängig von diesem aus einer bündigen Einschwenkstellung in eine Ausschwenkstellung bringbar ist, in der er zur Außenseite des Oberteils bzw. des Unterteils in einem Winkel größer als 90° steht.

Die Schwenklagerung Stellfuß und Stapelfuß in dem Grundgehäuse ist dabei so ausgeführt, daß der Stellfuß mit zwei Seitenschenkeln zwischen den Seitenschenkeln des Grundgehäuses und den Seitenschenkeln des Stapelfußes auf der Lagerwelle gelagert ist, daß die Seitenschenkel des Stellfußes in der Einschwenkstellung desselben an der Grundplatte des Grundgehäuses anliegen und in dem Bereich außerhalb der Standplatte des Stapelfußes mittels einer Verbindungsplatte verbunden sind, daß die Standplatte des Stapelfußes die Seitenschenkel des Stellfußes und die Seitenschenkel des Grundgehäuses überdeckt, daß die Verbindungsplatte des Stellfußes die Seitenschenkel des Grundgehäuses überdeckt, und daß die der Standplatte des Stapelfußes zugekehrten Stirnkanten der Seitenschenkel des Stapelfußes in den Einschwenkstellungen von Stapelfuß und Stellfuß in einem spitzen Winkel zur Standplatte des Stapelfußes stehen, der sich zu den freien Enden von Stapelfuß und Stellfuß hin öffnet.

Ist bei dem Tischgehäuse Ober-und Unterteil genau definiert, dann läßt sich der Aufwand dadurch noch reduzieren, daß im Bereich der Oberseite des Tischgehäuses nur Stapelaufnahmen in der vorgegebenen Teilung vorgesehen sind und daß die Unterseite des Tischgehäuses vier Einheiten mit Stapelfuß und Stellfuß aufweist. Die Stapelfüße und Stellfüße werden grundsätzlich an der Unterseite angebracht und ausgeschwenkt in Stapelaufnahmen eines darunter angeordneten Tischgehäuses eingeführt, dessen Oberseite nur diese Stapelaufnahmen trägt. Dabei ist bei Einhaltung derselben Teilung auch die Stapelung unterschiedlich tiefer Tischgehäuse möglich.

Ist dagegen vorgesehen, daß die Oberseite des Tischgehäuses vier Einheiten mit Stapelfuß und in der Teilung angeordnete Stapelaufnahmen aufweist, und daß die Unterseite des Tischgehäuses mit vier Einheiten mitt Stapelfuß oder Stapelfuß und Stellfuß versehen ist, dann lassen sich die Stapelfüße der Oberseite zum Abdecken der Befestigungsschrauben ausnützen. Die Stapelfüße können bei benachbarten Tischgehäusen eines Stapels dann auch wahlweise vom oberen zum unteren oder vom unteren zum oberen Tischgehäuse des Stapels ausgeschwenkt und so wechselseitig in Eingriff miteinander gebracht werden.

Die Erfindung wird anhand eines in den Zeichnungen dargestellten Ausführungsbeispiels näher erläutert. Es zeigt:

Fig. 1 in perspektivischer Ansicht schematisch ein Tischgehäuse mit Stapelfüßen und Stapelaufnahmen,

Fig. 2 einen Stapel von unterschiedlich tiefen Tischgehäusen in Seitenansicht,

Fig. 3 einen Längsschnitt durch eine Einheit aus Grundgehäuse mit Stapelfuß und Stellfuß und

Fig. 4 eine Teilansicht mit Teilschnitt der Einheit nach Fig. 3 in Draufsicht.

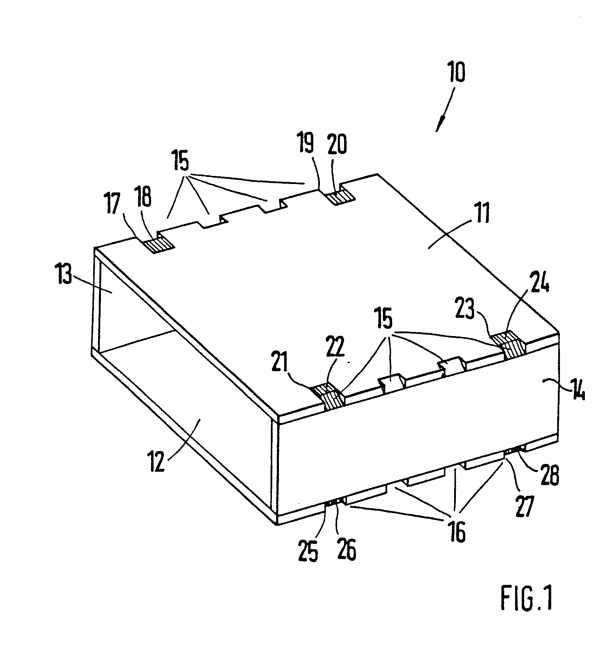

Das Tischgehäuse 10 nach Fig. 1 ist aus dem Oberteil 11, dem Unterteil 12 und den Seitenteilen 13 und 14 zusammengesetzt. Die Teile können jedoch auch einteilig zusammengefaßt sein. Im Bereich aller Kanten dieses Gehäuserahmens sind Stapelaufnahmen 15 bzw. 16 eingebracht. Die den Öffnungen des Gehäuserahmens zugekehrten Stapelaufnahmen 15 und 16 werden dabei von - schwenkbar gelagerten Stapelfüßen 18,20,22,24,26 und 28 gebildet, wenn diese in die bündige Einschwenkstellung gebracht sind. Diese Stapelfüße sind in Aussparungen 17,19,21,23,25 und 27 von Oberteil 11 und Unterteil 12 eingebracht. Auf die konstruktive Ausgestaltung der Stapelfüße und den Einbau in die Aussparungen wird später noch eingegangen.

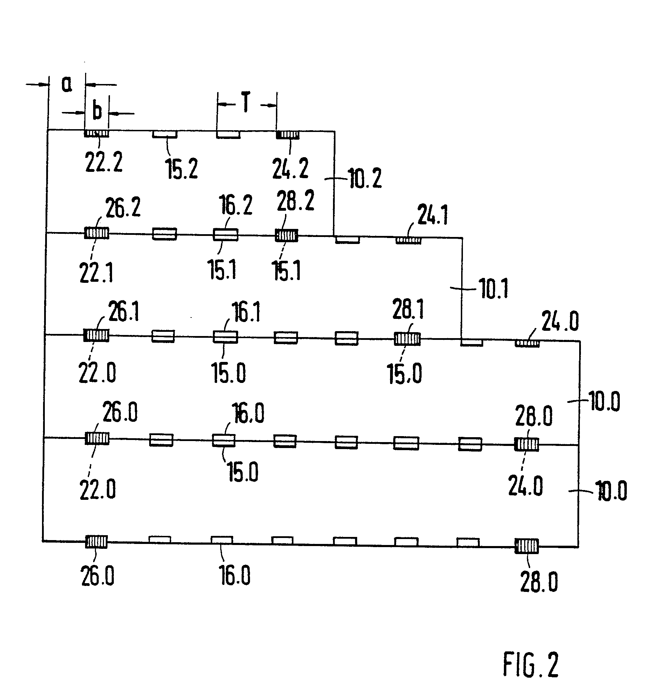

Wie Fig. 2 zeigt, sind die Stapelfüße jeweils in dem Abstand a von den Öffnungen der Gehäuserahmen entfernt angeordnet. Dieser Abstand entspricht dem Abstand a der Stapelaufnahmen 15 und 16. Die Breite b der Stapelfüße und der Stapelaufnahmen 15 und 16 ist gleich groß und so ergibt sich eine einheitliche Teilung T in der Verteilung der Stapelfüße und Stapelaufnahmen. Werden bei unterschiedlich tiefen Tischgehäusen 10.0, 10.1 und 10.2 diese Verteilungen und Abmessungen beibehalten, dann lassen sich diese Tischgehäuse in dem Stapel nach Fig. 2 unverschiebbar aufeinandersetzen. Das unterste Tischgehäuse 10.0 hat zwischen den ausgeschwenkten Stapelfüßen 26.0 und 28.0 sechs weitere Stapelaufnahmen 16.0 und zwischen den eingeschwenkten Stapelfüßen 22.0 und 24.0 der Oberseite sechs Stapelaufnahmen 15.0. Wird ein gleiches Tischgehäuse 10.0 aufgesetzt, dann sind die ausgeschwenkten Stapelfüße 26.0 und 28.0 des zweiten Tischgehäuses 10.0 in die Stapelaufnahmen 15.0 der Stapelfüße 22.0 und 24.0 des ersten Tischgehäuses 10.0 eingeführt.

Das Tischgehäuse 10.1 hat zwischen den Stapelfüßen 26.1 und 28.1 der Unterseite nur vier Stapelaufnahmen 16.1 und zwischen den Stapelfüßen 22.1 und 24.1 der Oberseite vier Stapelaufnahmen 15.1. Der ausgeschwenkte Stapelfuß 26.1 des Tischgehäuses 10.1 ist in die Stapelaufnahmen 15.0 des eingeschwenkten Stapelfußes 22.0 des Tischgehäuses 10.0 eingeführt, während der ausgeschwenkte Stapelfuß 28.1 des Tischgehäuses 10.1 in eine Stapelaufnahme 15.0 im Tischgehäuse 10.0 eingeführt ist. Schließlich weist das Tischgehäuse 10.2 zwischen den Stapelfüßen 26.2 und 28.2 der Unterseite nur noch zwei Stapelaufnahmen 16.2 und zwischen den Stapelfüßen 22.2 und 24.2 der Oberseite nur noch zwei Stapelaufnahmen 15.2 auf. Der ausgeschwenkte Stapelfuß 26.2 des Tischgehäuses 10.2 ist in die Stapelaufnahme 16.2 des eingeschwenkten Stapelfußes 22.1 des Tischgehäuses 10.1 eingeführt, während der ausgeschwenkte Stapelfuß 28.2 des Tischgehäusees 10.2 in eine Stapelaufnahme 15.1 des Tischgehäuses 10.1 eingeführt ist.

In Fig. 2 ist jeweils gezeigt, daß der Stapelfuß an der Unterseite des Tischgehäuses ausgeschwenkt ist und in die Stapelaufnahme eines eingeschwenkten Stapelfußes an der Oberseite eines darunter angeordneten Tischgehäuses eingeführt ist. Dieselbe Wirkung erhält man jedoch auch, wenn z.B. der Stapelfuß 26.2 an der Unterseite des Tischgehäuses 10.2 eingeschwenkt bleibt und dafür der Stapelfuß 22.1 des darunter angeordneten Tischgehäuses 10.1 nach oben ausgeschwenkt und in die Stapelaufnahme 16.2 des Stapelfußes 26.2 eingeführt wird.

Sind die Oberseite und die Unterseite des Tischgehäuses jeweils gleich mit Stapelfüßen und Stapelaufnahmen versehen, dann kann das Tischgehäuse in zwei um 180° verdrehten Stellungen verwendet werden. Dies hat zweifellos Vorteile im Aufwand. Wird jedoch die Oberseite und die Unterseite des Tischgehäuses definitiv festgelegt, dann genügt es, die Stapelfüße mit ihren Stapelaufnahmen nur auf der Unterseite der Tischgehäuse vorzusehen und die Oberseite nur mit Stapelaufnahmen auszugestalten. Dabei können dann auch die Stapelaufnahmen zwischen den Stapelfüßen der Unterseite entfallen, ohne auf die Stapelung unterschiedlich tiefer Tischgehäuse verzichten zu müssen.

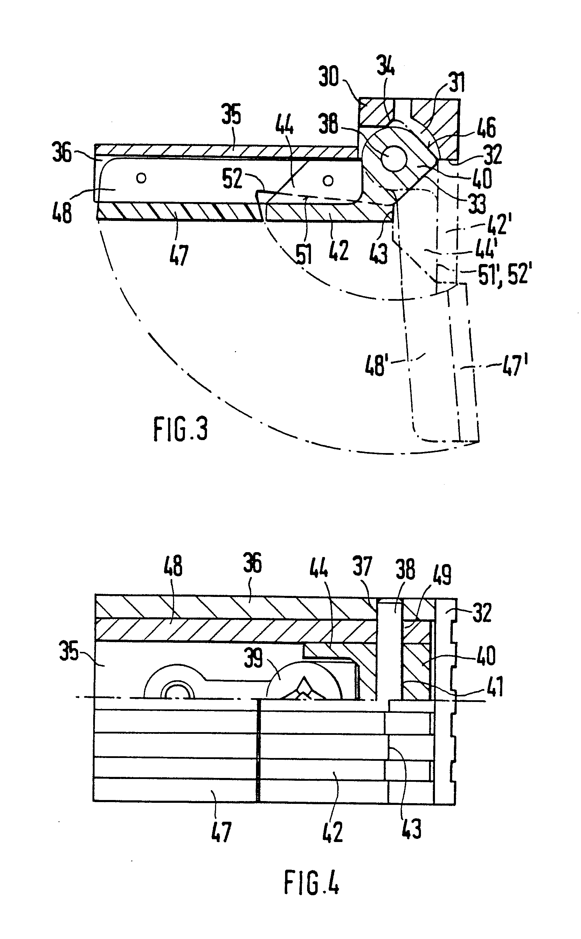

Die Ausgestaltung der Stapelfüße und der Stapelaufnahmen wird anhand eines in den Fig. 3 und Fig. 4 gezeigten Ausführungsbeispiels näher erläutert. Der Stapelfuß wird als Einheit vorgefertigt, wobei ein U-förmiges Grundgehäuse 30 verwendet wird, das in eine entsprechend geformte und bemessene Aussparung 17,19,21,23,25 oder 27 des Tischgehäuses eingebaut wird. Die Anordnung erfolgt in dem Bereich der sich in die Tiefe des Tischgehäuses erstreckenden Außenkanten, wie Fig. 1 zeigt. Das Grundgehäuse 30 besteht aus der Grundplatte 35 und den beiden Seitenschenkeln 36. An einem stirnseitigen Ende des Grundgehäuses 30 ist die Lageraufnahme 31 angeformt, die mit zwei Anschlagflächen 32 und 34 versehen ist. Im Bereich dieser Lageraufnahme 31 weisen die Seitenschenkel 36 Lagerbohrungen 37 für die Lagerwelle 38 auf, die in die Lagerbohrung 41 des Lagerblockes 40 des Stapelfußes eingeführt ist. Die Grundplatte 35 weist Bohrungen für Befestigungsschrauben 39 auf, die nicht nur zur Verbindung zwischen Grundgehäuse 30 und Tischgehäuse, sondern auch zur Verbindung des Oberteils 11 bzw. des Unterteils 12 mit dem Seitenteil 13 bzw. dem Seitenteil 14 dienen können.

An dem Lagerblock 40 sind die beiden Seitenschenkel 44 des Stapelfußes angeformt, die sich in der Einschwenkstellung an der Grundplatte 35 des Grundgehäuses 30 abstützen. Die Standplatte 42 verbindet die beiden Seitenschenkel 44 des Stapelfußes und schließt in der Einschwenkstellung bündig mit der Außenseite des Oberteils 11 bzw. des Unterteils 12 ab. die Standplatte 42 bildet mit der dem Lagerblock 40 zugekehrten Stirnseite die Gegenanschlagfläche 43, während der Lagerblock 40 selbst die Gegenanschlagfläche 46 für die Anschlagflächen 32 und 34 der Lageraufnahme 31 bildet. Auf diese Weise ist sichergestellt, daß der ausgeschwenkte Stapelfuß senkrecht zur zugekehrten Außenseite des Oberteils 11 bzw. des Unterteils 12 steht, wie das Bezugszeichen 42' der strichpunktiert gezeichneten Standplatte zeigt. Dabei stützen sich die Standplatte 42 mit der Gegenanschlagfläche Aushwenkstellung auch eine Begrenzung für die Ausschwenkbewegung des Stellfußes bildet. Dabei schlagen die Stirnseiten 52 der Seitenschenkel 48 des Stellfußes an die Unterseite 51 der Standplatte 42 des Stapelfußes an, wie die Bezugszeichen 51', 52' an den strichpunktiert eingezeichneten Stellungen von Stapelfuß und Stellfuß andeuten. Der Schwenkwinkel des Stapelfußes beträgt 90°, während der Stellfuß um den spitzen Winkel, den die Stirnseiten 52 der Seitenschenkel 48 des Stellfußes und die Unterseite 51 der Standplatte 42 des Stapelfußes in den Einschwenkstellungen einschließen, weiter ausgeschwenkt und daher entsprechend schräggestellt werden kann.

In der universell anwendbaren Ausgestaltung werden an der Ober-und Unterseite des Tischgehäuses derartige Einheiten aus Grundgehäuse, Stapelfuß und Stellfuß angebracht und bei einheitlicher Teilung entsprechend ausgebildete Stapelaufnahmen eingebracht. Es ist jedoch auch die vereinfachte Ausgestaltung realisierbar, bei der nur die Unterseite derartige Einheiten trägt, während die Oberseite nur die Stapelaufnahmen oder Einheiten aus Grundgehäuse und Stapelfuß trägt. Dabei dienen die Stapelfuße nur als Stapelaufnahmen und Abdeckklappen für benötigte Befestigungsschrauben.

Aus Fig. 3 ist auch die Form der Stapelaufnahmen erkennbar. Die Anschlagfläche 32 der Lageraufnahme 31 und die Gegenanschlagfläche 43 der Standfläche 42 begrenzen mit der in 135° dazu geneigten geraden Abschlußfläche 33 des Lagerblockes 40 die Stapelaufnahme mit einer Kontur, die der Kontur der dem Lagerblock 40 abgekehrten Stirnseite der Standplatte 42 mit den abgeschrägten Seitenschenkel 44 des Stapelfußes entspricht und das Stapelende des Stapelfußes bildet. Die reinen Stapelaufnahmen 15 und 16 43 an der Anschlagfläche 32 der Lageraufnahme 31 und die Gegenanschlagfläche 46 des Lagerblockes 40 an der Anschlagfläche 34 der Lageraufnahme 31 ab. Die Standplatte 42 überdeckt mit der Breite die Seitenschenkel 36 des Grundgehäuses 30, so daß sie in der Einschwenkstellung die zugeordnete Aussparung im Tischgehäuse vollständig schließt.

Auf derselben Lagerwelle 38 kann neben dem Stapelfuß auch noch ein Stellfuß gelagert werden. Dieser Stellfuß hat die beiden Seitenschenkel 48, die zwischen den Seitenschenkeln 36 des Grundgehäuses 30 und den Seitenschenkeln 44 des Stapelfußes auf der Lagerwelle 38 gelagert sind, wie die Lagerbohrung 49 zeigt. Der Stellfuß ist länger als der Stapelfuß und die beiden Seitenschenkel 48 sind nur außerhalb der Standplatte 42 des Stapelfußes über die Verbindungsplatte 47 miteinander verbunden. Die Seitenschenkel 48 des Stellfußes stützen sich in der Einschwenkstellung an der Grundplatte 35 des Grundgehäuses 30 ab, wobei die Außenseite der Verbindungsplatte 47 bündig mit der Außenseite des Oberteils 11 bzw. des Unterteils 12 und der Außenseite der Standplatte 42 des eingeschwenkten Stapelfußes abschließt, wie Fig. 3 erkennen läßt. Die Verbindungsplatte 47 überdeckt dabei auch die Seitenschenkel 36 des Grundgehäuses 30, um die entsprechend vergrößerte Aussparung im Tischgehäuse vollständig abzudecken.

Die der Standplatte 42 des Stapelfußes zugekehrten Stirnseiten 52 der Seitenschenkel 48 des Stellfußes bilden in der Einschwenkstellung von Stapelfuß und Stellfuß mit der Unterseite 52 der Standplatte 42 des Stapelfußes einen spitzen Winkel, der zu den freien Enden von Stapelfuß und Stellfuß hin offen ist. Damit wird erreicht, daß beim Ausschwenken des Stellfußes nicht nur der Stapelfuß zwangsweise mit ausgeschwenkt wird, sondern daß der Stapelfuß in der des Tischgehäuses werden als Nuten in die Kanten eingebracht, wobei der Nutgrund jeweils im Winkel von 135° zu den Außenseiten der angrenzenden Seitenwand 13 bzw. 14 und des Oberteils 11 bzw. des Unterteils 12 steht und über senkrecht zu diesen stehende Absätze in diese übergeht. Dabei weisen die senkrechten Absätze eine Abmessung auf, die durch die Dicke der Standplatte 42 des Stapelfußes vorgegeben ist.

Wie bereits erwähnt, kann an dem Tischgehäuse nur das Unterteil 12 mit Stapelfüßen oder mit Stapelfüßen und Stellfüßen versehen sein. Das Oberteil 11 und das Unterteil 12 des Tischgehäuses sind identisch ausgebildet und in gleicher Weise mit Aussparungen für die Stapelfüße oder die Stapelfüße und Stellfüße versehen. Die Aussparungen 17, 19, 21 und 23 des Oberteils 11 werden dann aber mittels einrastbarer Abdeckplatten verschlossen, in deren Kantenbereich Stapelaufnahmen 15 eingelassen sind.

## Ansprüche

1. Tischgehäuse für elektrotechnische Einrichtungen mit zwei Seitenwänden, einem Oberteil und einem Unterteil, die einen Rahmen mit zwei mittels Rückwand, Tür oder Sichtfenster verschließbare Offnungen bilden, bei dem in allen Eckbereichen des Ober-und des Unterteils Stellfüße schwenkbar gelagert und aus einer bündigen Einschwenkstellung in eine senkrecht zum Oberteil oder Unterteil stehende Ausschwenkstellung bringbar sind,
dadurch gekennzeichnet,
daß zumindest die Stellfüße des Unterteils (12) als Stapelfüße (26,28) ausgebildet sind, und
daß zumindest die in der Einschwenkstellung befindlichen Stapelfüße (18,20,22,24) des Oberteils Stapelaufnahmen (15,16) für die als Stapelenden ausgebildeten freien Enden von in die Ausschwenkstellung gebrachten Stapelfüßen benachbarter Tischgehäuse bilden.

2. Tischgehäuse nach Anspruch 1,
dadurch gekennzeichnet,
daß Seitenwände (13,14), Oberteil (11) und Unterteil (12) einen einteiligen Rahmen bilden.

3. Tischgehäuse nach Anspruch 1,
dadurch gekennzeichnet,
daß die Seitenwände (13,14) mit dem Oberteil (11) und dem Unterteil (12) verschraubt sind und
daß die Stapelfüße (18,20,22,24,26,28) die Befestigungsschrauben abdecken.

4. Tischgehäuse nach einem der Ansprüche 1 bis 3,
dadurch gekennzeichnet,
daß die Stapelfüße (18,20,22,24,26,28) in Aussparungen (17,19,21,23,25,27) schwenkbar gelagert sind, die im Bereich der Kanten in das Tischgehäuse eingebracht sind, an denen die Seitenwände (13,14) auf das Oberteil (11) oder das Unterteil (12) stoßen.

5. Tischgehäuse nach Anspruch 4,
dadurch gekennzeichnet,
daß die Stapelfüße (18,20,22,24,26,28) mittels Schwenkachsen(38) gelagert sind, die parallel zu diesen Kanten ausgerichtet sind.

6. Tischgehäuse nach einem der Ansprüche 1 bis 5,
dadurch gekennzeichnet,
daß zwischen den beiden Stapelfüßen (18,20; 22,24; 26,28) der Kanten weitere Stapelaufnahmen (15,16) in einheitlicher Teilung (T) angeordnet sind, die sich aus der Breite (b) der Stapelfüße (18,20,22,24,26,28) in Längsrichtung der Kanten plus dem Abstand (a) zwischen benachbarten Stapelaufnahmen (15,16) ergibt.

7. Tischgehäuse nach einem der Ansprüche 1 bis 6,
dadurch gekennzeichnet,
daß die Stapelfüße (18,20,22,24,26,28) jeweils in einem Abstand (a) von der zugekehrten Offnung des Tischgehäuses (10) entfernt angeordnet sind, der dem Abstand (a) zwischen benachbarten Stapelaufnahmen (15,16) entspricht.

8. Tiscchgehäuse nach einem der Ansprüche 1 bis 7,
dadurch gekennzeichnet,
daß die Tiefe desselben K.T + a beträgt, wobei K die Anzahl der Stapelaufnahmen (15,16) plus der Stapelfüße (18,20; 22,24; 26,28) pro Kante angibt und k gleich oder größer als zwei ist.

9. Tischgehäuse nach einem der Ansprüche 1 bis 8,
dadurch gekennzeichnet,
daß die Stapelaufnahmen (15,16) in den Kanten des Tischgehäuses (10) und an den in Einschwenkstellung befindlichen Stapelfüßen (18,20,22,24,26,28) als von den Kanten ausgehende Nuten ausgebildet sind, deren Nutgrund jeweils im Winkel von 135° zu den Außenseiten der benachbarten Seitenwand (13 bzw. 14) und des benachbarten Oberteils (11) bzw. des benachbarten Unterteils (12) steht und jeweils über einen senkrecht zu diesen stehenden Absatz in diese übergeht, und
daß das Stapelende des ausgeschwenkten Stapelfußes in seiner Kontur an diesen Nutgrund mit seinen Übergängen angepaßt ist.

10. Tischgehäuse nach einem der Ansprüche 1 bis 9,
dadurch gekennzeichnet,
daß jeder Stapelfuß (18,20,,22,24,26,28) in einem Grundgehäuse (30) schwenkbar gelagert ist, das in eine der Aussparungen (17,19,21,23,25,27) des Tischgehäuses (10) eingesetzt und mit diesem verbunden ist.

11. Tischgehäuse nach Anspruch 10,
dadurch gekennzeichnet,
daß das Grundgehäuse (30) im wesentlichen U-förmig ausgebildet ist und eine Grundplatte (35) und zwei Seitenschenkel (36) aufweist,

daß die Grundplatte (35) an einer Stirnseite des Grundgehäuses (30) in eine angeformte Lageraufnahme (31) für einen Lagerblock (40) des Stapelfußes übergeht,

daß die Seitenschenkel (36) des Grundgehäuses (30) im Bereich dieser Lageraufnahme (31) mit Lagerbohrungen (37) für eine in die Lagerbohrung (41) des Lagerblockes (40) des Stapelfußes eingeführte Lagerwelle (38) versehen sind, und

daß die Grundplatte (42) des Stapelfußes in der Einschwenkstellung die Seitenschenkel (36) des Grundgehäuses (30) überdeckt.

12. Tischgehäuse nach Anspruch 10 und 11, dadurch gekennzeichnet,

daß die Lageraufnahme (31) des Grundgehäuses (30) mit Anschlagflächen (32,34) versehen ist, an denen Gegenanschlagflächen (43,46) des Lagerblockes (40) des in die Ausschwenkstellung gebrachten Stapelfußes zur Anlage kommen.

13. Tischgehäuse nach Anspruch 12, dadurch gekennzeichnet,

daß der Stapelfuß in der Ausschwenkstellung senkrecht zur Außenseite des Oberteils (11) bzw. des Unterteils (12) steht.

14. Tischgehäuse nach einem der Ansprüche 10 bis 13, dadurch gekennzeichnet,

daß der Stapelfuß U-förmig gestaltet ist und aus einer Standplatte (42) und zwei Seitenschenkeln (44) besteht, die an dem Lagerblock (40) angeformt sind,

daß die Außenseite der Grundplatte (42) in der Einschwenkstellung bündig mit der Außenseite des Oberteils (11) bzw. des Unterteils (12) abschließt, während die Seitenschenkel (44) an der Grundplatte (35) des Grundgehäuses (30) anliegen,

daß die dem Lagerblock (40) abgekehrten Stirnseiten der Standplatte (42) und der abgeschrägten Seitenschenkel (44) das Stapelende des Stapelfußes bilden und

daß die dem Lagerblock (40) zugekehrte, als Gegenanschlagfläche (43) dienende Stirnseite der Standplatte (42) und der Lagerblock (40) des Stapelfußes in Verbindung mit der bei eingeschwenktem Stapelfuß freiliegenden Anschlagfläche (32) der Lageraufnahme (31) des Grundgehäuses (30) eine Stapelaufnahme bilden.

15. Tischgehäuse nach einem der Ansprüche 1 bis 14, dadurch gekennzeichnet,

daß mit dem Stapelfuß auf derselben Schwenkachse ein Stellfuß schwenkbar gelagert ist, der länger als der Stapelfuß ist und abhängig von diesem aus einer bündigen Einschwenkstellung in eine Ausschwenkstellung bringbar ist, in der er zur Außenseite des Oberteils (11) bzw. des Unterteils (12) in einem Winkel größer als 90° steht.

16. Tischgehäuse nach einem der Ansprüche 1 bis 15, dadurch gekennzeichnet,

daß der Stellfuß mit zwei Seitenschenkeln (48) zwischen den Seitenschenkeln (36) des Grundgehäuses (30) und den Seitenschenkeln (44) des Stapelfußes auf der Lagerwelle (38) gelagert ist,

daß die Seitenschenkel (48) des Stellfußes in der Einschwenkstellung desselben an der Grundplatte (35) des Grundgehäuses (30) anliegen und in dem Bereich außerhalb der Standplatte (42) des Stapelfußes mittels einer Verbindungsplatte (47) verbunden sind,

daß die Standplatte (42) des Stapelfußes die Seitenschenkel (48) des Stellfußes und die Seitenschenkel (35) des Grundgehäuses (30) überdeckt,

daß die Verbindungsplatte (47) des Stellfußes die Seitenschenkel (36) des Grundgehäuses (30) überdeckt, und

daß die der Standplatte (42) des Stapelfußes zugekehrten Stirnkanten der Seitenschenkel (48) des Stapelfußes in den Einschwenkstellungen von Stapelfuß und Stellfuß in einem spitzen Winkel zur Standplatte (42) des Stapelfußes stehen, der sich zu den freien Enden von Stapelfuß und Stellfuß hin öffnet.

17. Tischgehäuse nach einem der Ansprüche 1 bis 16, dadurch gekennzeichnet,

daß im Bereich der Oberseite des Tischgehäuses (10) nur Stapelaufnahmen (15) in der vorgegebenen Teilung (T) vorgesehen sind und

daß die Unterseite des Tischgehäuses (10) vier Einheiten mit Stapelfuß und Stellfuß aufweist.

18. Tischgehäuse nach einem der Ansprüche 1 bis 16, dadurch gekennzeichnet,

daß die Oberseite des Tischgehäuses (10) vier Einheiten mit Stapelfuß und in der Teilung (T) angeordnete Stapelaufnahmen (15) aufweist, und

daß die Unterseite des Tischgehäuses (10) mit vier Einheiten mit Stapelfuß oder Stapelfuß und Stellfuß versehen ist.

19. Tischgehäuse nach Anspruch 17 oder 18, dadurch gekennzeichnet,

daß das Oberteil (11) des Tischgehäuses (10) identisch wie das Unterteil (12) mit Aussparungen (17,19,21,23,25,27) für Stapelfüße oder Stapelfüße und Stellfüße versehen sind, und

daß die Aussparungen (17,19,21,23) des Oberteils (11) mittels einrastbarer, mit Stapelaufnahmen (15) versehener Abdeckplatten verschließbar sind.

FIG.1

A 6077

FIG.2

A 6077

0 262 427

FIG.3

FIG.4

A 6077